Europäisches
Patentamt

European
Patent Office

Office européen
des brevets

(11)  **EP 3 104 397 B1**

(12)  **EUROPEAN PATENT SPECIFICATION**

(45) Date of publication and mention
of the grant of the patent:
**11.10.2017  Bulletin 2017/41**

(51) Int Cl.:
**H01L 21/225** *(2006.01)*     **H01L 31/18** *(2006.01)*

(21) Application number: **15171263.5**

(22) Date of filing: **09.06.2015**

(54) **METHOD FOR DOPING SILICON WAFERS**

VERFAHREN ZUR DOTIERUNG VON SILICIUMWAFERN

PROCÉDÉ DE DOPAGE DE TRANCHES DE SILICIUM

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**14.12.2016  Bulletin 2016/50**

(73) Proprietor: **International Solar Energy Research
Center Konstanz E.V.
78467 Konstanz (DE)**

(72) Inventor: **Mihailetchi, Valentin Dan
78464 Konstanz (DE)**

(74) Representative: **Westphal, Mussgnug & Partner
Patentanwälte mbB
Am Riettor 5
78048 Villingen-Schwenningen (DE)**

(56) References cited:
**EP-A1- 2 077 587     US-A1- 2012 083 105**

**Description**

The invention relates to the production of doped semiconductor components, especially semiconductor components created by doping of silicon wafers, such as photovoltaic cells.

This process, e.g. the P-type doping of silicon wafers for which typically boron is used as described e.g. in US 6 548 378 B1 or US 2012/0083105 A1, is usually performed in a diffusion oven, which can be realized e.g. as a horizontal or a vertical oven. The wafers are deposited inside the oven on a support, which is often referred to as "boat" and typically made of $SiO_2$ or SiC, and controlled flows of a carrier gas (e.g. $N_2$ or Ar), a doping agent (e.g. liquid $BBr_3$ or $BCl_3$) and the reactive gas (e.g. $O_2$, $H_2$ or $H_2O$) are led into the inner volume of the oven.

Looking as an example at a process using the above-mentioned materials, during a first phase of the diffusion process, the deposition, the vapor $BBr_3$ reacts with oxygen inside the reaction chamber following the chemical process:

$$4BBr_3 + 3O_2 \rightarrow 2B_2O_3 + 6Br_2$$

The liquid $B_2O_3$ condenses on the silicon wafers and reacts to produce $SiO_2$ and elemental boron as follows:

$$2B_2O_3 + 3Si \rightarrow 4B^+ + 3SiO_2 \text{ (borosilicate glass)}$$

It is mainly during the second phase of the diffusion, the drive-in, that elemental boron diffuses into the silicon wafers as well as into the borosilicate glass (BSG) layer grown in-situ on the silicon surface. The role of the carrier gas is to drive doping agent and reactive gas to the surface of the silicon wafers.

Naturally, in order to obtain a product with well-defined properties it is essential to obtain an identical doping profile if several wafers are treated simultaneously. This simultaneous treatment is essential for any industrial application of the process, because in order to minimize the fabrication cost, the desired doping concentration into the silicon wafers should be obtained in a short process time and, concomitantly, on a large wafer load.

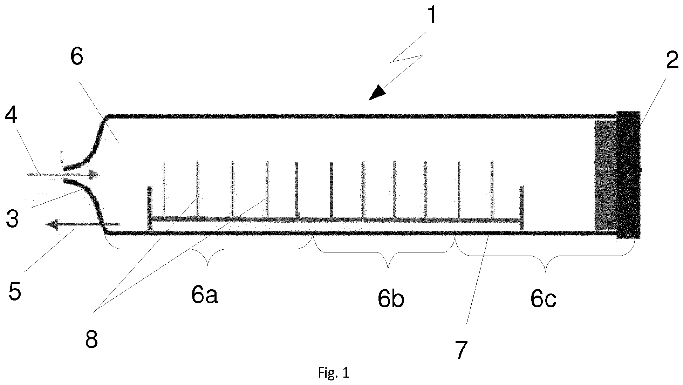

In order to achieve a uniform doping it is imperative that the gaseous circulation during the deposition phase ensures that homogeneous wetting of the wafers that are arrange over the entire length of the reactor takes place. It is know that, under operation conditions, the volumetric proportion of gases, temperature, and pressure are the critical parameters to control the dynamics of fluids and reaction kinetics in the reactor. However, this homogenous wetting is particularly difficult to achieve in an industrial production, where a horizontal furnace is used whose chamber is relatively long and densely packed with wafers, and in which the gases are introduced through one of the walls of the chamber, typically the terminal wall (as shown below in figure 1).

The reason behind these problems is that depletion of doping agent and reactive gas occurs, i.e. these gases are partly used while they are carried through the oven so that the atmosphere under which the reaction takes place varies e.g. between the terminal wall and the door of the oven which may be located on the opposite side of the terminal wall.

Naturally, due to the high economic relevance of these processes several attempts have been made to overcome this problem. Traditionally, the parameter that has been used to create a possibility for compensation of these effects is temperature. By now, it is a common features of the ovens used that they are "zone ovens" which means that temperature in different regions of the inner space of the oven may be adjusted individually. An example for this approach is found in US 6 548 378 B1 for a vertical oven.

More recently, it has been suggested in US 2012/0083105 A1 to use the pressure inside the reaction chamber as a parameter to obtain a more homogenous wetting of the wafers in the inner volume of the oven and operate under reduced pressure conditions.

In spite of these attempts to overcome the aforementioned problems, the problem to provide a method for doping, especially boron doping of silicon wafers, which allows for simultaneous processing of a large number of wafers in a given oven or reactor still persists.

This problem is solved by the method for doping silicon wafers with the features of claim 1. Advantageous refinements of the method are subject of the dependent claims.

The method for doping of silicon wafers according to this invention relates to diffusion doping. Accordingly, for its application a conventional diffusion oven is used, in other words an oven that comprises at least a door for loading and unloading of the wafers, an inner volume, gas inlets for a reaction gas, a doping gas and a carrier gas and means for modifying the flow rate of said reaction gas, said doping gas and said carrier gas into the interior volume of the diffusion oven. These means for modifying the flow rate of reaction gas, doping gas and carrier gas can e.g. be realized as valves with a variable throughput that are preferably electrically operated and controlled by a remote controller that is in an especially advantageous embodiment a programmable controller.

As typical for diffusion based processes for doping of silicon wafers, the method according to the invention comprises the steps of loading silicon wafers into the diffusion oven, heating the diffusion oven in accordance with a predetermined temperature profile at least during a deposition time, letting reaction gas, doping gas and carrier gas flow simultaneously into the inner volume and unloading the doped silicon wafers from the diffusion oven.

For the sake of clarity, it should be pointed out that whereas the order of the above listing of steps is reasonable, it is not meant to imply that this sequence of actions has to be performed in this order. Specifically, it is not ruled out that silicon wafers are loaded into a pre-heated oven.

Note also that the wording does only imply that during performance of the method reaction gas, doping gas and carrier gas flow simultaneously for some amount of time, which is called deposition phase in this decription, but not necessarily all the time. E.g., carrier gas may flow longer to clean the reaction chamber and/or speed up cooling down the processed silicon wafers.

The term "predetermined temperature profile" is used in order to express the fact that the temperature profile for the diffusion process may vary for different diffusions to be achieved. Therefore, typically for given points of time in the deposition process either a target temperature is defined, e.g. in the memory of a controller, and said controller controls the heating means of the oven -potentially different for different zones of the oven-, preferably based on feedback from temperature sensors of the oven, to reach this temperature.

It is essential for the invention that during the deposition time the ratio of the flow rate of reaction gas and flow rate of doping gas (further on sometimes simply referred to as "ratio" for the sake of brevity) is changed at least once from a first ratio to a second ratio and/or the flow rate of the carrier gas is changed at least once from a first flow rate to a second flow rate (further on sometimes simply referred to as "flow rate" for the sake of brevity).

Due to the fact that the ratio of flow rate of reaction gas and flow rate of doping gas has a critical influence on the formation of the intermediate reaction product that is to condense on the silicon wafers and the gas particles have a preferred direction of propagation, changing this ratio influences the spatial distribution of the intermediate reaction product in the inner volume of the diffusion product and, accordingly, the amount of material that condenses on a given wafer, thus allowing for a more homogenous doping result over the entire set of Silicon wafers.

An alternative way to obtain this improved homogeneity which can also be combined with the variation of this ratio is changing the flow rate of the carrier gas at least once from a first flow rate to a second flow rate during the deposition time.

The ratio of the reactive gas and doping gas influences the reaction rate and thus the amount of intermediate product produced after the gases have reacted with each other for a given period of time. The role of the carrier gas is to drive the other gases into the chamber and distribute them. Therefore, a higher flow rate of the carrier gas will drive a given ensemble of gas particles on average further into the interior volume of the diffusion oven in a given period of time. Therefore, the invention can be realized as well if alternatively or additionally the flow rate of the carrier gas is changed at least once during the deposition time.

Specifically, the inventors have found that the variation of the ratio of flow rate of reaction gas and flow rate of doping gas typically leads to a more significant improvement of the result of doping procedures that are performed under ambient pressure whereas the variation of the flow rate of the carrier gas leads to a more significant improvement for doping procedures that are performed under reduced pressure relative to ambient pressure.

In an advantageous embodiment of the method, the first ratio and/or the first flow rate is chosen in such a way that it leads to homogenously doped wafers in the vicinity of the gas inlets if applied throughout the deposition time and the second ratio and/or the second flow rate is chosen in such a way that it leads to homogenously doped wafers in the region of the interior volume that lies opposite of the gas inlets if applied throughout the deposition time. Alternatively, as the numbering of the ratios used in the language of this application does not imply a necessary temporal order of the thus defined conditions, the second ratio and/or the second flow rate can be chosen in such a way that it leads to homogenously doped wafers in the vicinity of the gas inlets if applied throughout the deposition time and the first ratio and/or the second flow rate is chosen in such a way that it leads to homogenously doped wafers in the region of the interior volume that lies opposite of the gas inlets if applied throughout the deposition time. That such a choice of parameters is possible is shown below for an example. Also, considerations for choosing the ratios, flow rates and process conditions are discussed below.

The preferred way of influencing this ratio is variation of the reactive gas flow while the doping gas flow is kept constant.

Advantageously, in order to obtain the ratios and/or flow rates to be used the method the method further comprises the step of determining the first ratio and/or first flow rate that leads to homogenously doped wafers in the vicinity of the gas inlets if applied throughout the deposition time and determining the second ratio and/or second flow rate that leads to homogenously doped wafers in the region of the interior volume that lies opposite of the gas inlets if applied throughout the deposition time. This may be done by a manufacturer of the oven for a series of standard doping procedures or by a processing plant or institute before a doping procedure is defined or performed for the first time or before a new production run is started.

As mentioned above, by variation of the ratio of reaction gas and doping gas the spatial distribution of the reaction product that is to condense on the wavers in the inner volume of the diffusion oven. Therefore, especially for very long ovens with many wafers it may be advantageous if the method further comprises changing the ratio of the flow rate of reaction gas and flow rate of doping gas during the deposition time at least once to at least a third ratio and/or changing the flow rate of the carrier gas during the deposition time at least once to at least a third flow rate.

In other words, if one notices that using two ratios and/or flow rates optimized for wafers near the oven door and near the gas inlets, respectively, leads to quality problems in the middle section of the oven, this may be remedied by applying further ratios and/or flow rates optimized for these positions. Accordingly, if only a third ratio is used, the third ratio is chosen in such a way that it leads to homogenously doped wafers in the middle region of interior volume of the oven if applied throughout the deposition time, and if only a third flow rate is used, it is chosen in such a way that it leads to homogenously doped wafers in the middle region of interior volume of the oven if applied throughout the deposition time.

Therefore, a sequence of ratios of reactive gas and doping gas and/or flow rates can be defined. It is advantageous if the thus defined ratios and/or rates are repeated more than once. The reason for this is that the diffusion process is time dependent, so that varying process conditions frequently will lead to a more homogenous result than varying the process conditions only once. Preferably, the defined sequence is repeated cyclically (i.e. in the same order of process conditions, leading e.g. a sequence of the conditions A, B and C to a repeated in the order ABCABCABC...) or anti-cyclically (i.e. reversing the order of the process conditions after each completed sequence, leading e.g. a sequence of the conditions A, B and C to a repeated in the order ABCCBAABC...).

A further parameter for influencing/improving the homogeneity achieved by the production process is a phase shift of the changing of the flow rate of the carrier gas occurs relative to the switching between the ratios. The inventors have noted that the size of the phase shift that leads to the best results is dependent on the pressure of the oven atmosphere under deposition conditions. In atmospheric pressure deposition, the phase shift should be maximized, but with lower atmospheric pressure the positive effects of this phase shift are first reduced and finally reverted, so that in the case of deposition under reduced pressure atmosphere carrier gas flow, gas flow of reactive gas and gas flow of the doping gas are preferably changed together.

As pointed out previously, on the one hand it is desirable that variation of the process conditions is effected sufficiently quick to occur in the same phase of the process of diffusion of the dopant into the silicon wafer. However, it turns out that too quick a change affects the process adversely, because no equilibrium is formed in the inner volume of the diffusion oven. Therefore, it is advantageous if the switching between the ratios occurs less than once per minute.

The invention is next explained using figures that illustrate specific aspects and embodiments of the invention using examples. The figures show:

Fig.1:     a schematic picture of a diffusion oven according to the state of the art,

Fig.2a-c:  the sheet resistance of wafers from the gas zone (Fig. 2a), the center zone (Fig. 2b) and the load zone (Fig. 2c) of the oven obtained by a state of the art doping process performed with a first set of fixed gas flow parameters,

Fig.3a-c:  the sheet resistance of wafers from the gas zone (Fig. 3a), the center zone (Fig. 3b) and the load zone (Fig. 3c) of the oven obtained by the same state of the art doping process, but performed with a second set of fixed gas flow parameters,

Fig.4a:    a diagram showing an example for a variation of gas flow over deposition time in accordance with the variant of this invention in which the ratio of the flow rate of reaction gas and flow rate of doping gas is changed,

Fig. 4b:   a diagram showing an example for a variation of gas flow over deposition time in accordance with the variant of this invention in which the flow rate of the carrier gas is changed,

Fig.5a-c:  the sheet resistance of wafers from the gas zone (Fig. 5a), the center zone (Fig. 5b) and the load zone (Fig. 5c) of the oven obtained by a doping process in which the first set of gas flow parameters from the example process of Fig. 2a-c and the second set of gas flow parameters from the example process of Fig. 3a-c are used alternatingly while keeping the remaining process parameters identical, and

Fig.6:     a diagram showing a second example for a variation of gas flow over deposition time in accordance with this invention.

Fig.7:        a diagram showing the gas flow during an entire deposition process according to the invention

Figure 1 shows schematically an example of a diffusion oven 1 with door 2 at one end and terminal wall 3 with one or more gas inlets 4 and one or more gas outlets 5 at the opposite end. In the inner volume 6 of the diffusion oven 1 there is a processing boat 7 on which several silicon wafers 8 are arranged. The section of the inner volume 6 of the diffusion oven 1 that is located near the terminal wall 3 is typically referred to as gas zone 6a, the section that is located near the door 2 is typically referred to as load zone 6c, and the section between gas zone 6a and load zone 6c is typically referred to as center zone 6b. Frequently, the heating means for the diffusion oven 1, which are not shown in figure 1, are arranged in such a way that temperatures and/or the heating power can be adjusted individually for gas zone 6a, center zone 6b and load zone 6c. If used for the method according to the invention, the diffusion oven 1 may be operating under normal pressure conditions or under reduced pressure relative to ambient pressure.
The gas flow through gas inlets 4 is controlled by valves (not shown), which can usually be set remotely by a controller (not shown) to provide a given flow rate of the respective gas type flowing into the inner volume 6 of the diffusion oven 1.

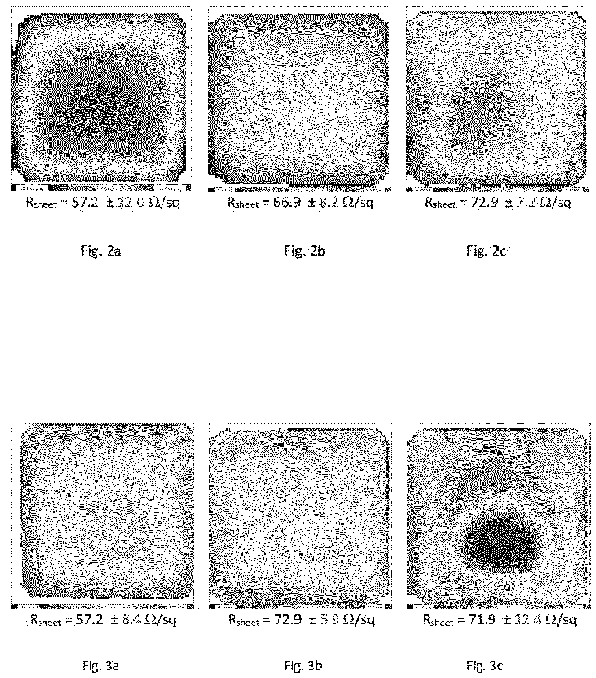

Figures 2a-c and 3a-c show the sheet resistance of wafers from the gas zone 6a (c.f. Fig. 2a,3a), the center zone 6b (c.f.
Fig. 2b,3b) and the load zone 6c (c.f. Fig. 2c,3c) of the diffusion oven 1 obtained by a state of the art doping process performed with a first set of fixed gas flow parameters and a second set of fixed gas flow parameters, respectively. More specifically, in each case a fully loaded boat with 200 silicon wafers 8 was exposed for 26 minutes to a temperature over the heating zones that was adjusted to 970°C +/- 3°C to a particular gas flow.
In the reaction that led to the results shown in figure 2a-c, this gas flow was characterized by the following parameters, which will be referred to as flow ratio 1 from now on:

$$\text{BBr}_3 \text{ doping gas } = 70 \text{ cm}^3/\text{min} \pm 0.5\%$$

$$\text{O}_2 \text{ reactive gas } = 53 \text{ cm}^3/\text{min} \pm 0.5\%$$

$$\text{N}_2 \text{ carrier gas } = 15.6 \text{ L/min} \pm 0.3\%.$$

In contrast to that, in the reaction that led to the results that are shown in figure 3a-c, this gas flow was characterized by the following parameters, which will be referred to as flow ratio 2 from now on:

$$\text{BBr}_3 \text{ doping gas } = 70 \text{ cm}^3/\text{min} \pm 0.5\%$$

$$\text{O}_2 \text{ reactive gas } = 80 \text{ cm}^3/\text{min} \pm 0.5\%$$

$$\text{N}_2 \text{ carrier gas } = 15.6 \text{ L/min} \pm 0.3\%.$$

Note that in flow ratio 1 and flow ratio 2 of these examples the same flow rates of doping gas and reactive gas are used and only the amount of reactive gas is varied. It should be pointed out that in order to realize the invention, it is also possible to vary flow rates of carrier gas and/or doping gas. The most relevant parameter for influencing the zone in which good homogeneity is achieved is the ratio of doping gas to reactive gas that is used. However, the inventors have found that the preferred way of influencing this ratio is variation of the reactive gas flow.
One reason for this preference lies in the way the doping gas is provided. The above-presented flow rate of the doping gas is actually the rate at which $BBr_3$ is carried into the oven as a result of bubbling 70 $cm^3/min$ $N_2$ gas through a bottle containing liquid $BBr_3$. Changing this flow condition renders control of the $BBr_3$ pickup inaccurate, especially if this change is repeated.
In addition, it is important to keep the amount of $BBr_3$ that is brought into the oven to a minimum in order to avoid oversaturation of Boron at the Silicon surface can occur, which leads to the formation of an undesirable Boron rich layer and to minimize the amount of $B_2O_3$ that will deposit on oven walls and oven door, which increases the amount of cleaning the oven and thus increases maintenance costs.

The results shown in Figures 2a-c and 3a-c, respectively, illustrate clearly the key result for this invention that whereas the conventional approach using fixed flow rates of the gases at fixed temperature settings that is applied does not allow for obtaining good homogeneity for the entire set of wafers that is processed under these conditions, it is possible to choose the gas flow parameters in such a way that the desired homogeneity is achieved either in the load zone 6c or in the gas zone 6a of the diffusion oven 1.

The exact process parameters that have to be used to achieve this depend e.g. on the type of the diffusion oven 1, the number of silicon wafers 8 to be processed in the oven 1 and the exact parameters of the desired doping process and therefore should preferably be established individually before starting standardized production runs. For standard processes, this may be done by the oven manufacturer for a given oven type, but alternatively it is possible to determine the parameters most suited for a given purpose by trial runs with systematic variation of gas flow parameters and analyzing the thus obtained results on silicon wafers 8 from different zones 6a,6b,6c of the diffusion oven 1 individually.

A good starting point for such investigations are the conditions of a conventional diffusion process for the diffusion oven 1. It should be stressed that the method of this invention works also for diffusion ovens 1 operated at low pressure, as described in US 2012/0083105 A1.

Preferably, the next parameter to be varied is the flow of reactive gas. As a general trend, from the above mentioned starting point lowering values of reactive gas tend to lead to improved homogeneity in the load zone 6c whereas increasing values of reactive gas tend to lead to improved homogeneity in the gas zone 6a. Further degrees of freedom comprise an adaption of the carrier gas flow rate and the temperature setting of the zones 6a,6b,6c of the diffusion oven 1. Once all parameters have been optimized, it should be tested whether the reactive gas flow is still the one that led to the best results or if a further iteration through the reaction parameters can lead to notable improvements.

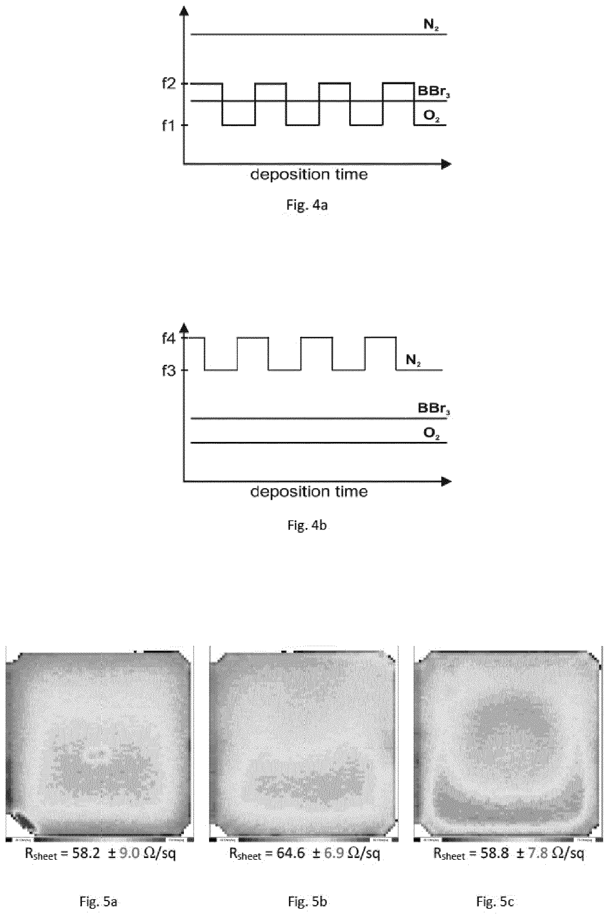

Figure 4a illustrates an example diagram showing the gas flow regulation as a function of time as proposed by this invention. In this example, the flow rate of doping gas and carrier gas are kept constant and the flow rate of the reactive gas is changed between a high flow value f2, creating improved conditions for homogeneity in the gas zone 6a, and a low flow value f1, creating improved conditions for homogeneity in the load zone 6c.

In this example, the cycling between these conditions is repeated four times over the deposition process, so that there are four periods of time with high reactive gas flow f2 and four periods of time with low reactive gas flow f1.

It has been found by the inventors that switching between a high ratio of reactive gas to carrier gas and a low ratio of these gases several times leads to better results than applying only one change of the ratio, but it is also important to allow for enough time between subsequent flow rate changes for gas flow conditions to stabilize. For the processes investigated by the inventors of this invention, leaving a time period of a few minutes between subsequent gas flow changes led to the best results.

It should also be stressed that the effect is not specific for a given doping gas, reaction gas and/or carrier gas. For example, all doping gases that can be used for Boron doping, especially $BBr_3$ and $BCl_3$ may be used together with the respective reaction gases, especially $O_2$, $H_2$ or $H_2O$ steam, and carrier gases, especially $N_2$ or Ar. Also, it can be adapted to the respective time scale of a given doping process as long as enough settling time for the gas flow after a change of gas flow settings can be provided.

To illustrate the effectiveness of this approach, figures 5 a-c show the results obtained using the process conditions described above for flow ratio 1 and flow ratio 2, respectively in connection with a gas flow regulation as shown in the diagram of figure 4a. Even at first sight it is evident that homogeneity of the properties of wafers from the different zones 6a,6b,6c of the diffusion oven 1 is significantly better than the one obtained using the conventional approaches of figures 2a-c or 3a-c. With this increased homogeneity, it becomes possible to dope more silicon wafers 8 simultaneously, e.g. by operating longer ovens and/or larger processing boats.

Fig. 4b is diagram showing an example for a variation of gas flow over deposition time in accordance with the variant of this invention in which the flow rate of the carrier gas is changed during deposition time, which also increases homogeneity of the achieved doping characteristics over the length of the oven. This variant is especially effective in doping procedures in which the oven is operated at reduced pressure relative to the ambient pressure.

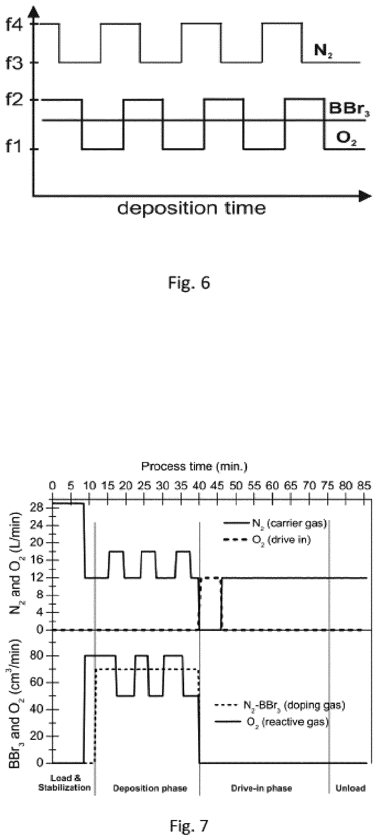

Further improvement of the results can be achieved e.g. when operating the gas flow during deposition time in accordance with the scheme shown in figure 6. The difference between this scheme and the scheme shown in figure 4a and 4b, respectively, is that there are variations of both the ratio of the flow rate of reaction gas and flow rate of doping gas is changed at least once from a first ratio to a second ratio and the carrier gas flow, e.g. between 12 l/min and 18 l/min, are changed. In the example displayed in Figure 6, the changes of the carrier gas flow are intercalated between the reactive gas flow variations, so that in this example during 50% of the time a given doping gas flow setting is set the higher carrier gas flow f4 is present and the remaining 50% coincides with the lower carrier gas flow f3. However, it is to be expected that other timing of the carrier gas flow variations relative to the reactive gas flow variations may be preferable as a function of the respective doping process and diffusion oven parameters. Specifically, the inventors tentatively assume that under reduced pressure conditions a reduction of the phase shift may lead to improved results.

Next, an entire doping process is described with reference to Fig. 7. Fig. 7 is a diagram showing in its upper half flow rates of $N_2$ (solid line, upper half) and $O_2$ when used for drive in (dashed line, upper half) and in its lower half

flow rates of $O_2$ when used as reactive gas (solid line, lower half) and $BBr_3$ doping gas (dashed line, lower half). As explained above, the presented flow rate of the doping gas is actually the rate at which $BBr_3$ is carried into the oven as a result of bubbling 70 $cm^3$/min $N_2$ gas through a bottle containing liquid $BBr_3$.

At the start of the process, i.e. at process time 0 min, the oven, which is typically already pre-heated, e.g to a temperature of 830°C, is loaded with the wafers. As shown in Figure 7, this occurs under high $N_2$ (i.e. carrier gas) flow.

After loading, it is preferable to allow the conditions in the oven to settle for a stabilization time after loading to allow different furnace zones to reach a predetermined temperature difference. During this stabilization time, the carrier gas flow is reduced and reaction gas flow, e.g. $O_2$ flow, is started. However, this is not yet part of the deposition phase, because no doping gas is flowing.

The deposition phase is started by switching on the doping gas flow only after the stabilization time is over. Typically, at the time the deposition phase is started the temperature is also being ramped up, e.g. to 970°C with a temperature increase of 8°C/minute. The deposition phase is ended after a defined time by switching off the $BBr_3$ flow.

Subsequently, cool-down to unload temperature (e.g. 850°C with a ramp of 4°C/minute) is begun and the drive-in phase is started. In the example displayed as Figure 7, the drive-in phase is started under $O_2$ flow with switched off $N_2$ carrier gas in order to achieve oxidation before $O_2$ flos is stopped and $N_2$ flow is switched back on. Note that in this situation the $O_2$ is no longer used as reaction gas to provide the dopant chemically, as doping gas is no longer provided.

Finally, the doped wavers are unloaded.

List of reference numerals

| | |
|---|---|
| 1 | diffusion oven |
| 2 | door |
| 3 | terminal wall |
| 4 | gas inlet |
| 5 | gas outlet |
| 6 | inner volume |
| 6a | gas zone |
| 6b | center zone |
| 6c | load zone |
| 7 | processing boat |
| 8 | silicon wafer |
| f1 | gas flow |
| f2 | gas flow |
| f3 | gas flow |
| f4 | gas flow |

**Claims**

1.  Method for doping of silicon wafers (8) using a diffusion oven (1), said diffusion oven (1) having a door (2) for loading and unloading of the silicon wafers (8), an inner volume (6), gas inlets (4) for a reaction gas, a doping gas and a carrier gas and means for modifying the flow rate of said reaction gas, said doping gas and said carrier gas into the interior volume (6) of the diffusion oven (1), said method comprising the steps of

    - loading silicon wafers (8) into the diffusion oven (1),
    - heating the diffusion oven (1) in accordance with a predetermined temperature profile at least during a deposition time,
    - letting reaction gas, doping gas and carrier gas flow simultaneously into the interior volume (6) and
    - unloading the doped silicon wafers (8) from the diffusion oven (1)

    **characterized in that** during the deposition time in which reaction gas, doping gas and carrier gas flow simultaneously into the interior volume (6) of the diffusion oven (1), the ratio of the flow rate of reaction gas and flow rate of doping gas is changed at least once from a first ratio to a second ratio and/or the flow rate of the carrier gas is changed at least once from a first flow rate to a second flow rate.

2.  Method for doping of silicon wafers according to claim 1,

**characterized in that** the ratio of the flow rate of reaction gas and flow rate of doping gas is changed at least once from a first ratio to a second ratio and the first ratio or the second ratio is chosen in such a way that it leads to homogenously doped silicon wafers (8) in the vicinity of the gas inlets if applied throughout the deposition time and the second ratio or the first ratio is chosen in such a way that it leads to homogenously doped wafers in the region of the interior volume (6) that lies opposite of the gas inlets if applied throughout the deposition time.

3. Method for doping of silicon wafers according to claim 2,
**characterized in that** the method further comprises the step of determining the first ratio that leads to homogenously doped wafers in the vicinity of the gas inlets if applied throughout the deposition time and determining the second ratio that leads to homogenously doped wafers in the region of the interior volume (6) that lies opposite of the gas inlets if applied throughout the deposition time.

4. Method for doping of silicon wafers according to claim 2 or 3,
**characterized in that** the method further comprises changing the ratio of the flow rate of reaction gas and flow rate of doping gas during the deposition time at least once to at least a third ratio.

5. Method for doping of silicon wafers according to claim 4,
**characterized in that** the third ratio is chosen in such a way that it leads to homogenously doped wafers in the center region (6b) of the interior volume (6) of the diffusion oven 1 if applied throughout the deposition time.

6. Method for doping of silicon wafers according to claim 1,
**characterized in that** flow rate of the carrier gas is changed at least once from a first flow rate to a second flow rate and the first flow rate or the second flow rate is chosen in such a way that it leads to homogenously doped silicon wafers (8) in the vicinity of the gas inlets if applied throughout the deposition time and the second flow rate or the first flow rate is chosen in such a way that it leads to homogenously doped wafers in the region of the interior volume (6) that lies opposite of the gas inlets if applied throughout the deposition time.

7. Method for doping of silicon wafers according to claim 6,
**characterized in that** the method further comprises the step of determining the first flow rate that leads to homogenously doped wafers in the vicinity of the gas inlets if applied throughout the deposition time and determining the second flow rate that leads to homogenously doped wafers in the region of the interior volume (6) that lies opposite of the gas inlets if applied throughout the deposition time.

8. Method for doping of silicon wafers according to claim 6 or 7,
**characterized in that** the method further comprises changing the flow rate of the carrier gas during the deposition time at least once to at least a third flow rate.

9. Method for doping of silicon wafers according to claim 8,
**characterized in that** the third flow rate is chosen in such a way that it leads to homogenously doped wafers in the center region (6b) of the interior volume (6) of the diffusion oven 1 if applied throughout the deposition time.

10. Method for doping of silicon wafers according to one of the previous claims,
**characterized in that** the switching between the ratios and/or the switching of the flow rate of the carrier gas occurs several times during the deposition time, especially cyclically or anti-cyclically.

11. Method for doping of silicon wafers according to one of the previous claims,
**characterized in that** the ratio of the flow rate of reaction gas and flow rate of doping gas is changed at least once from a first ratio to a second ratio and the flow rate of the carrier gas is changed at least once from a first flow rate to a second flow rate and that the changing of the flow rate of the carrier gas occurs phase-shifted relative to the switching between the ratios.

12. Method for doping of silicon wafers according to one of the previous claims,
**characterized in that** the switching between the ratios and/ or the switching between the flow rates of the carrier gas occurs less than once per minute.

**Patentansprüche**

1. Verfahren zum Dotieren von Silizium-Wafern (8) unter Verwendung eines Diffusions-Ofens (1), wobei besagter Diffusions-Ofen (1) eine Tür (2) zum Laden und Entladen der Silizium-Wafer (8), einen Innenraum (6), Gaseinlässe (4) für ein Reaktionsgas, ein Dotierungsgas und ein Trägergas und Mittel zur Modifikation der Flussrate des besagten Reaktionsgases, des besagten Dotierungsgases und des besagten Trägergases in den Innenraum (6) des Diffusions-Ofens (1) hat, wobei das besagte Verfahren die Schritte

   - Laden von Silizium-Wafern (8) in den Diffusions-Ofen (1),
   - Beheizen des Diffusions-Ofens (1) gemäß einem vorgegebenen Temperaturprofil zumindest während einer Depositionszeit,
   - gleichzeitiges Einströmen lassen von Reaktionsgas, Dotierungsgas und Trägergas in den Innenraum (6) und
   - Entladen der Silizium-Wafer (8) aus dem Diffusions-Ofen (1)
   aufweist,
   **dadurch gekennzeichnet, dass** während der Depositions-Zeit, in der Reaktionsgas, Dotierungsgas und Trägergas gleichzeitig in den Innenraum (6) des Diffusions-Ofens (1) einströmen, das Verhältnis zwischen der Flussrate des Reaktionsgases und der Flussrate des Dotierungsgases wenigstens einmal von einem ersten Verhältnis zu einem zweiten Verhältnis geändert wird und/oder die Flussrate des Trägergases wenigstens einmal von einer ersten Flussrate zu einer zweiten Flussrate geändert wird.

2. Verfahren zum Dotieren von Silizium-Wafern nach Anspruch 1,
   **dadurch gekennzeichnet, dass** das Verhältnis der Flussrate des Reaktionsgases und der Flussrate des Dotierungsgases wenigstens einmal von einem ersten Verhältnis zu einem zweiten Verhältnis geändert wird und dass das erste Verhältnis oder das zweite Verhältnis so gewählt ist, dass es zu homogen dotierten Silizium-Wafern (8) in der Nachbarschaft der Gaseinlässe führt, wenn es über die Depositionszeit hinweg angewendet wird und das zweite Verhältnis oder das erste Verhältnis so gewählt ist, dass es zu homogen dotierten Wafern in dem Bereich des Innenraums (6), der den Gaseinlässen gegenüber liegt, führt, wenn es über die Depositionszeit hinweg angewendet wird.

3. Verfahren zum Dotieren von Silizium-Wafern nach Anspruch 2,
   **dadurch gekennzeichnet, dass** das Verfahren ferner den Schritt des Bestimmens des ersten Verhältnisses, das zu homogen dotierten Wafern in der Nachbarschaft der Gaseinlässe führt, wenn es über die Depositionszeit hinweg angewendet wird und das Bestimmen des zweiten Verhältnisses, das zu homogen dotierten Wafern in dem Bereich des Innenraums (6), der den Gaseinlässen gegenüber liegt, führt, wenn es über die Depositionszeit hinweg angewendet wird, umfasst.

4. Verfahren zum Dotieren von Silizium-Wafern nach Anspruch 2 oder 3,
   **dadurch gekennzeichnet, dass** das Verfahren ferner wenigstens einmal während der Depositionszeit das Verändern des Verhältnisses zwischen der Flussrate des Reaktionsgases und der Flussrate des Dotierungsgases zu wenigstens einem dritten Verhältnis umfasst.

5. Verfahren zum Dotieren von Silizium-Wafern nach Anspruch 4,
   **dadurch gekennzeichnet, dass** das dritte Verhältnis so gewählt ist, dass es zu homogen dotierten Wafern im Zentralbereich (6b) des Innenraums des Diffusions-Ofens 1 führt, wenn es über die Depositionszeit hinweg angewendet wird.

6. Verfahren zum Dotieren von Silizium-Wafern nach Anspruch 1,
   **dadurch gekennzeichnet, dass** die Flussrate des Trägergases wenigstens einmal von einer ersten Flussrate zu einer zweiten Flussrate geändert wird und dass die erste Flussrate oder die zweite Flussrate so gewählt ist, dass sie zu homogen dotierten Silizium-Wafern (8) in der Nachbarschaft der Gaseinlässe führt, wenn sie über die Depositionszeit hinweg angewendet wird und die zweite Flussrate oder die erste Flussrate so gewählt ist, dass sie zu homogen dotierten Wafern in dem Bereich des Innenraums (6), der den Gaseinlässen gegenüber liegt, führt, wenn sie über die Depositionszeit hinweg angewendet wird.

7. Verfahren zum Dotieren von Silizium-Wafern nach Anspruch 6,
   **dadurch gekennzeichnet, dass** das Verfahren ferner den Schritt des Bestimmens der ersten Flussrate, die zu homogen dotierten Wafern in der Nachbarschaft der Gaseinlässe führt, wenn sie über die Depositionszeit hinweg angewendet wird und des Bestimmens der zweiten Flussrate, die zu homogen dotierten Wafern in dem Bereich des Innenraums (6), der den Gaseinlässen gegenüber liegt, führt, wenn sie über die Depositionszeit hinweg angewendet wird, umfasst.

8. Verfahren zum Dotieren von Silizium-Wafern nach Anspruch 6 oder 7, **dadurch gekennzeichnet, dass** das Verfahren ferner wenigstens einmal während der Depositionszeit das Verändern der Flussrate des Trägergases und der Flussrate des Dotierungsgases zu wenigstens einer dritten Flussrate umfasst.

9. Verfahren zum Dotieren von Silizium-Wafern nach Anspruch 8, **dadurch gekennzeichnet, dass** die dritte Flussrate so gewählt ist, dass sie zu homogen dotierten Wafern im Zentralbereich (6b) des Innenraums des Diffusions-Ofens 1 führt, wenn es über die Depositionszeit hinweg angewendet wird.

10. Verfahren zum Dotieren von Silizium-Wafern nach einem der vorstehenden Ansprüche, **dadurch gekennzeichnet, dass** das Wechseln zwischen den Verhältnissen und/oder das Wechseln zwischen den Flussraten mehrmals während der Depositionszeit, insbesondere zyklisch oder anti-zyklisch erfolgt.

11. Verfahren zum Dotieren von Silizium-Wafern nach einem der vorstehenden Ansprüche, **dadurch gekennzeichnet, dass** das Verhältnis zwischen der Flussrate des Reaktionsgases und der Flussrate des Dotierungsgases wenigstens einmal von einem ersten Verhältnis zu einem zweiten Verhältnis geändert wird und die Flussrate des Trägergases wenigstens einmal von einer ersten Flussrate zu einer zweiten Flussrate geändert wird und dass das Ändern der Flussrate des Trägergases phasenverschoben zum Ändern zwischen den Verhältnissen erfolgt.

12. Verfahren zum Dotieren von Silizium-Wafern nach einem der vorstehenden Ansprüche, **dadurch gekennzeichnet, dass** das Umschalten zwischen den Verhältnissen und/oder das Umschalten zwischen den Flussraten des Trägergases weniger oft als einmal pro Minute erfolgt.

**Revendications**

1. Procédé de dopage de tranches de silicium (8) en utilisant un four à diffusion (1), ce four à diffusion (1) ayant une porte (2) permettant le chargement et le déchargement des tranches de silicium (8), un volume interne (6), des entrées (4) d'un gaz de réaction, d'un gaz de dopage et d'un gaz porteur, et des moyens permettant de modifier le débit du gaz de réaction, du gaz de dopage et du gaz porteur dans le volume interne (6) du four à diffusion (1), ce procédé comprenant des étapes consistant à :

- charger des tranches de silicium (8) dans le four à diffusion (1),
- chauffer le four à diffusion (1) conformément à un profil de température prédéfini au moins pendant un temps de dépôt,
- faire circuler le gaz de réaction, le gaz de dopage et le gaz porteur simultanément dans le volume interne (6), et
- décharger les tranches de silicium dopées (8) du four à diffusion (1), **caractérisé en ce qu'**
au cours du temps de dépôt dans lequel le gaz de réaction, le gaz de dopage et le gaz porteur circulent simultanément dans le volume interne (6) du four à diffusion (1), le rapport du débit du gaz de réaction et du débit du gaz de dopage est modifié au moins une fois entre un premier rapport et un second rapport et/ou le débit du gaz porteur est modifié au moins une fois entre un premier débit et un second débit.

2. Procédé de dopage de tranches de silicium conforme à la revendication 1, **caractérisé en ce que** le rapport du débit du gaz de réaction et du débit du gaz de dopage est modifié au moins une fois entre un premier rapport et un second rapport, et le premier rapport ou le second rapport est choisi de sorte qu'il conduise à des tranches de silicium (8) dopées de manière homogène au voisinage des entrées de gaz s'il est utilisé pendant la totalité du temps de dépôt, et le second rapport ou le premier rapport est choisi de sorte qu'il conduise à des tranches de silicium (8) dopées de manière homogène dans la région du volume interne (6) située à l'opposé des entrées de gaz s'il est utilisé pendant la totalité du temps de dépôt.

3. Procédé de dopage de tranches de silicium conforme à la revendication 2, **caractérisé en ce qu'**

**EP 3 104 397 B1**

il comprend en outre une étape consistant à déterminer le premier rapport qui conduit à des tranches dopées de manière homogène au voisinage des entrées de gaz s'il est utilisé pendant la totalité du temps de dépôt, et à déterminer le second rapport qui conduit à des tranches dopées de manière homogène dans la région du volume interne (6) située à l'opposé des entrées de gaz s'il est utilisé pendant la totalité du temps de dépôt.

4. Procédé de dopage de tranches de silicium conforme à la revendication 2 ou 3,
**caractérisé en ce qu'**
il comprend en outre une étape consistant à modifier le rapport du débit du gaz de réaction et du débit du gaz de dopage pendant le temps de dépôt au moins une fois de sorte qu'il soit égal à au moins un troisième rapport.

5. Procédé de dopage de tranches de silicium conforme à la revendication 4,
**caractérisé en ce que**
le troisième rapport est choisi de sorte qu'il conduise à des tranches dopées de manière homogène dans la région centrale (6b) du volume interne (6) du four à diffusion (1) s'il est utilisé pendant la totalité du temps de dépôt.

6. Procédé de dopage de tranches de silicium conforme à la revendication 1,
**caractérisé en ce que**
le débit du gaz porteur est modifié au moins une fois entre un premier débit et un second débit, et le premier débit ou le second débit est choisi de sorte à ce qu'il conduise à des tranches de silicium (8) dopées de manière homogène au voisinage des entrées de gaz s'il est utilisé pendant la totalité du temps de dépôt, et le second débit ou le premier débit est choisi de sorte qu'il conduise à des tranches dopées de manière homogène dans la région du volume interne (6) située à l'opposé des entrées de gaz s'il est utilisé pendant la totalité du temps de dépôt.

7. Procédé de dopage de tranches de silicium conforme à la revendication 6,
**caractérisé en ce qu'**
il comprend en outre une étape consistant à déterminer le premier débit qui conduit à des tranches dopées de manière homogène au voisinage des entrées de gaz s'il est utilisé pendant la totalité du temps de dépôt et à déterminer le second débit qui conduit à des tranches dopées de manière homogène dans la région du volume interne (6) située à l'opposé des entrées de gaz s'il est utilisé pendant la totalité du temps de dépôt.

8. Procédé de dopage de tranches de silicium conforme à la revendication 6 ou 7
**caractérisé en ce qu'**
il comprend en outre une étape consistant à modifier le débit du gaz porteur au cours du temps de dépôt au moins une fois de sorte qu'il soit égal à au moins un troisième débit.

9. Procédé de dopage de tranches de silicium conforme à la revendication 8,
**caractérisé en ce que**
le troisième débit est choisi de sorte qu'il conduise à des tranches dopées de manière homogène dans la région centrale (6b) du volume interne (1) du four à diffusion (1) s'il est utilisé pendant la totalité du temps de dépôt.

10. Procédé de dopage de tranches de silicium conforme à l'une des revendications précédentes,
**caractérisé en ce que**
la commutation entre les rapports et/ou la commutation du débit du gaz porteur est (sont) effectuée(s) plusieurs fois au cours du temps de dépôt, en particulier de manière cyclique ou anticyclique.

11. Procédé de dopage de tranches de silicium conforme à l'une des revendications précédentes,
**caractérisé en ce que**
le rapport du débit du gaz de réaction et du débit du gaz de dopage est modifié au moins une fois entre un premier rapport et un second rapport et le débit du gaz porteur est modifié au moins une fois entre un premier débit et un second débit, et la modification du débit du gaz porteur est décalée en phase par rapport à la commutation entre les rapports.

12. Procédé de dopage de tranches de silicium conforme à l'une des revendications précédentes,
**caractérisé en ce que**
la commutation entre les rapports et/ou la commutation entre les débits du gaz porteur est (sont) effectuée(s) moins d'une fois par minute.

11

Fig. 1

R_sheet = 57.2 ± 12.0 Ω/sq

Fig. 2a

R_sheet = 66.9 ± 8.2 Ω/sq

Fig. 2b

R_sheet = 72.9 ± 7.2 Ω/sq

Fig. 2c

R_sheet = 57.2 ± 8.4 Ω/sq

Fig. 3a

R_sheet = 72.9 ± 5.9 Ω/sq

Fig. 3b

R_sheet = 71.9 ± 12.4 Ω/sq

Fig. 3c

Fig. 4a

Fig. 4b

$R_{sheet} = 58.2 \pm 9.0 \ \Omega/sq$

Fig. 5a

$R_{sheet} = 64.6 \pm 6.9 \ \Omega/sq$

Fig. 5b

$R_{sheet} = 58.8 \pm 7.8 \ \Omega/sq$

Fig. 5c

Fig. 6

Fig. 7

## REFERENCES CITED IN THE DESCRIPTION

**Patent documents cited in the description**

- US 6548378 B1

- US 20120083105 A1